# EUROPEAN PATENT APPLICATION

(11) **EP 2 222 148 A1**
(43) Date of publication of application: **25.08.2010**
(21) Application number: 08706431.7
(22) Date of filing: 30.01.2008
(51) Int. Cl.: H05K 3/00, C23F 1/08

(54) **ROLLERS FOR TRANSPORTING THIN SUBSTRATE AND CHEMICAL TREATMENT METHOD USING THE SAME**

(30) Priority: 30.11.2007 CN 200710188268
(71) Applicant: Wuxi Suntech Power Co., Ltd., New District Wuxi Jiangsu 214-028 (CN)
(72) Inventor: JI, Jingjia, Wuxi Jiangsu 214028 (CN); ARTES, Granham, Wuxi Jiangsu 214028 (CN); SHI, Zhengrong, Wuxi Jiangsu 214028 (CN)
(74) Representative: Solf, Alexander
(86) International application number: PCT/CN2008/000241
(87) International publication number: WO 2009/070946

(57) **Abstract**

A roller group for transporting a thin substrate (16) comprises an upper roller (12) fixed to an upper roller shaft (10) and a lower roller (18) fixed to a lower roller shaft (10), the upper and lower rollers rotating reversely at the same linear velocity in a clockwise direction and a counter-clockwise direction respectively to allow the thin substrate to move towards a certain direction. The upper roller includes a fixed roller and a plurality of elastic pieces secured on the fixed roller around its outer circumference surface. A method for performing a chemical treatment by using the above roller group for transporting a thin substrate comprises: using one or more sets of the roller groups to allow the thin substrate to continuously move towards one direction, so as to perform a continuous wet-chemical treatment to the thin substrate using a solution. The upper roller can ensure the smooth transporting of the thin substrate in any case even if the thin substrate disengages from the lower roller, to the effect that performs the continuous wet-chemical treatment.

## Description

### Field of the Invention

The present invention relates to a roller group and a method for performing a chemical treatment by using the same. More particularly, the present invention relates to a roller group for transporting a thin substrate and a method for performing a continuous wet-chemical treatment to the surface of the thin substrate by using the same.

### Background of the Invention

In the electronic manufacturing industry production, it is a common industrial operation to perform a wet-chemical treatment to the surface of a thin substrate. The so-called wet-chemical treatment involves the operation of performing etching, depositing film or cleaning to the surface of the thin substrate using a chemical solution. For example, the steps of electronic circuit defining and circuit board cleaning in the printed circuit board manufacturing process belong to the wet-chemical treatment. Also, in the production process of solar cells, texturing and cleaning steps of a semiconductor silicon thin substrate also belong to the wet-chemical treatment.

In the early electronic manufacturing industry production, a method of non-continuous operation is generally used to perform a wet-chemical treatment to the surface of the thin substrate. The so-called non-continuous wet-chemical treatment involves hanging the thin substrate by any fixture or inserting the thin substrate into any carrying box, and then putting vertically the fixture or carrying box into a chemical tank filled with a chemical solution to perform the wet-chemical treatment to the surface of the thin substrate. The non-continuous wet-chemical operation is **characterized in that** the thin substrate is stationary relative to the chemical solution.

Since the thin substrate is stationary relative to the chemical solution, it is hard to maintain the uniformity of concentration of the chemical solution over the surface of the thin substrate. The ununiformity is especially obvious in the case that the area of the thin substrate is relatively large, or the space between the thin substrates is relatively small. Therefore, one of the drawbacks of a non-continuous wet-chemical surface treatment is the difficulty of controlling the uniformity of concentration of the chemical solution on the thin substrate surface. Usually, a difference is present in the concentrations of the chemical solutions between the periphery and center of the thin substrate, as well as between the upper and lower surfaces of the thin substrate, and thus the quality of the wet-chemical surface treatment to the thin substrate is affected.

Also, since the thin substrate is stationary relative to the chemical solution, another drawback of the non-continuous wet-chemical surface treatment is the difficulty of controlling the temperature uniformity of the chemical solution on the thin substrate surface. The temperature ununiformity is especially obvious in the case that the temperature of the wet-chemical treatment to the thin substrate is higher or lower than a room temperature. In particular, in the case that the chemical reaction at the thin substrate surface is an exothermic or endothermic reaction, the temperature ununiformity may result in an abnormal performance of the wet-chemical reaction at the thin substrate surface.

Yet another drawback of the non-continuous wet-chemical surface treatment is the difficulty of loading/unloading the thin substrate onto/from any fixture and carrying box. Such loading and unloading generally are very complicated manual operations which require a lot of manpower, and more importantly, the thin substrate will be easily damaged during these processes, and thus the production cost will be increased.

In order to overcome the various drawbacks of the non-continuous wet-chemical surface treatment, engineers have developed a continuous wet-chemical surface treatment technology.

The early continuous wet-chemical surface treatment technology uses a group of fixed upper and lower rollers, which horizontally and continuously transports the thin substrate to and through various chemical solution tanks, and thus the purpose of performing the continuous wet-chemical treatment to the surface of the thin substrate is achieved. The main advantage of applying the continuous wet-chemical treatment to the thin substrate is that the concentration and temperature of the chemical solution on the thin substrate surface can be controlled to be very uniform. During the continuous wet-chemical treatment operation, the thin substrate surface driven by a pair of the upper and lower rollers moves relative to the chemical solution, and thus the uniformity of concentration and temperature of the chemical solution on the thin substrate surface can be ensured.

Another advantage of the continuous wet-chemical surface treatment technology is to avoid the operation of loading/unloading the thin substrate onto/from various fixtures and carrying boxes. During the continuous wet-chemical surface treatment, the thin substrate can be directly placed horizontally on a continuous wet-chemical surface processor, and transported by the lower rollers of the continuous wet-chemical surface processor to each chemical tank for various wet-chemical surface treatments. The application of the continuous wet-chemical surface processor advantages the continuous production and automation of the semiconductor industry.

With the development of the semiconductor industry, the thin substrates applied become thinner, larger and softer. For example, in the semiconductor solar cell industry, a silicon sheet for making solar cells is generally less than 200 micron in thickness. And in the semiconductor printed circuit boards industry, a flexible polymeric material has been employed as the substrate of the semiconductor printed circuit boards.

However, in the traditional continuous wet-chemical surface treatment equipment, an upper and lower roller group is designed in a fixed type, that is, one or more rollers are fixed on one roller shaft. The upper and lower rollers are respectively fixed on the upper and lower roller shafts. The upper and lower rollers can be symmetrical or asymmetrical to each other as needed. The drawback of such a fixed roller design is the difficulty of ensuring the same spacing between the respective upper and lower rollers, in other words, it is hard to ensure the same pressure between the upper and lower rollers. Therefore, when the thin substrate is transported by such a fixed upper and lower roller group, either the transportation can not be achieved because the upper and lower rollers cannot simultaneously contact the thin substrate, or the thin substrate will be damaged because the pressure applied on the thin substrate is too large due to the too small spacing between the upper and lower rollers. Obviously, the traditional fixed roller design has become increasingly unable to meet the requirements of a modern semiconductor industry.

US patent No. 6, 971, 505 discloses a roller group design solution to solve the above problem. The design solution changes the traditional means that both the upper and lower rollers are fixed, and designs the upper roller as a floating roller that is capable of freely moving upwards, downwards, leftwards and rightwards. This design can allow the upper roller to move freely within a certain range, and thus a constant pressure on the thin substrate during the transportation of the thin substrate is guaranteed. In fact, in this design solution, the pressure applied on the thin substrate corresponds to the gravity of the upper floating roller. Therefore, the design of the upper floating roller can control the pressure applied on the thin substrate between the upper and lower roller group, ensure that the thin substrate can be continuously transmitted by the roller groups and will not cause a mechanical damage to the roller groups.

Although the design of the upper floating roller can maintain the pressure on the thin substrate constant, its feature of moving will cause problems in operation. First, since the upper floating roller can move back and forth, in many cases the upper and lower surfaces of the thin substrate will receive forces in different directions, which may force the thin substrate to sway around during movement and thus to be damaged.

Another problem of the upper floating roller is that, when the lower surface of the thin substrate receives a force greater than the gravity of the floating roller, for example when the lower surface is washed or dried by air flow, the thin substrate may float upwards and disengage from the lower roller. After the thin substrate disengages from the lower roller, due to uncertainty of the direction of the force received from the upper floating roller, the thin substrate in this case may stagnate and even be drawn back, causing the damage to the thin substrate.

Therefore, the design of the upper floating roller can not fully solve the problem of the fixed rollers.

### Summary of the Invention

One purpose of the present invention is to provide a roller group in which an upper roller can always maintain the same linear velocity as a lower roller.

Another purpose of the present invention is to provide a roller group for transporting a thin substrate, in which an upper roller can apply a certain pressure on the upper surface of the thin substrate to make it contact with a lower roller.

A further purpose of the present invention is to provide a roller group for transporting a thin substrate, in which an upper roller can make the thin substrate be driven smoothly even if the thin substrate does not contact a lower roller.

Yet another purpose of the present invention is to provide a method for performing a chemical treatment to a thin substrate by using the above roller group.

To this end, an aspect of the present invention provides a roller group for transporting a thin substrate. The roller group comprises an upper roller fixed to an upper roller shaft and a lower roller fixed to a lower roller shaft. The upper and lower roller shafts driven by their respective driving shafts rotate the upper and lower rollers at the same linear velocity in a clockwise direction and a counter-clockwise direction respectively, so as to allow the thin substrate passing between the upper and lower rollers to move towards a certain direction under the driving of the roller group.

The upper roller includes a fixed roller and a plurality of elastic pieces secured on the fixed roller around its outer circumference surface. The fixed roller is round or polygonal in a section. One end or both ends of the elastic piece may be secured on the fixed roller. The width of the upper roller and of the lower roller along their axes is less or greater than the width of the thin substrate. The upper and lower rollers are made of metal, metal oxide, metal alloy, semiconductor material or polymer material. The lower roller includes a fixed roller and elastic pieces secured on the fixed roller around its outer circumference surface. Or, the surface of the lower roller is mounted with an O-shape ring or engraved with a pattern to increase the friction with the thin substrate.

Another aspect of the present invention provides a method for performing a chemical treatment by using the above roller group for transporting a thin substrate. The method comprises: using one or more sets of the roller groups to allow the thin substrate to continuously move towards one direction, so as to perform the continuous wet-chemical treatment to the thin substrate using a solution. The solution is water or a chemical solution. The continuous wet-chemical treatment includes the steps of performing surface etching, surface depositing, surface cleaning, surface pattern defining, water washing or drying to the thin substrate.

In the roller group and the method for performing a chemical treatment by using the same of the present invention, on the basis of the feature of stability of the fixed rollers being maintained, with the structure of elastic pieces it can be ensured that the upper roller can always apply a constant force on the thin substrate in any case, and thus the thin substrate can be driven smoothly so as to be successfully performed with the continuous wet-chemical treatment in any case, even in the case that the thin substrate disengages from the lower roller.

### Brief Description of the Drawings

Fig.1 is a schematic view showing that one end of an elastic piece of an upper roller in a roller group for transporting a thin substrate according to the first embodiment of the present invention is secured on a fixed roller having a non-circular section;
Fig.2 is a schematic view showing that the thin substrate collectively driven by a lower roller and the elastic pieces of the upper roller shown in Fig. 1 moves towards one direction;
Fig.3 is a schematic view showing that a plurality of the upper rollers shown in Fig. 1 is mounted on a shaft; and
Fig.4 is a schematic view showing that both ends of an elastic piece of an upper roller in a roller group for transporting a thin substrate according to the second embodiment of the present invention are secured on a fixed roller having a circular section.

### Detailed Description on the Embodiments

Now, the detail description of the present invention will be made with reference to the accompanying drawings.

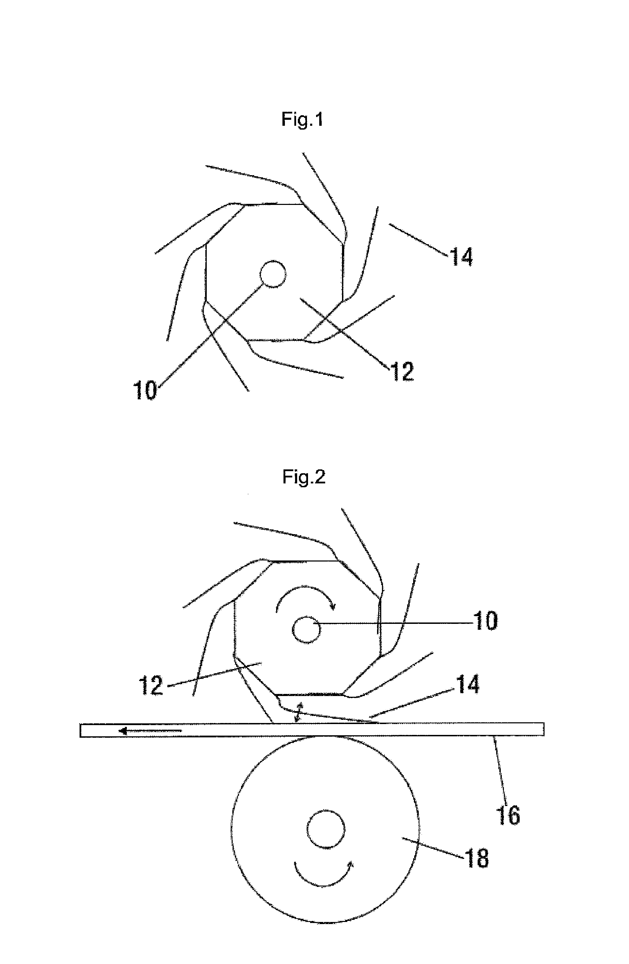

Fig.1 is a schematic view showing that one end of an elastic piece of an upper roller in a roller group for transporting a thin substrate according to the first embodiment of the present invention is secured on a fixed roller having a non-circular section.

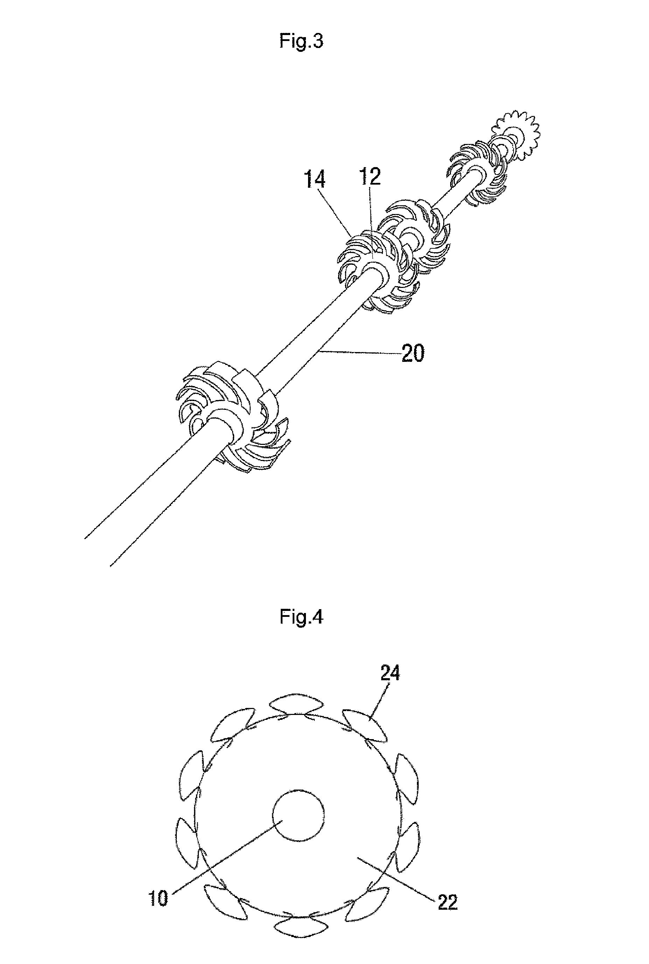

As shown in Fig.1, in the roller group of this invention, the upper roller includes a fixed roller 12 having a polygonal section and a series of elastic pieces 14 secured on its periphery. The fixed roller 12 has a hole 10 at its center for fixing the upper roller on a transmission shaft 20 (see Fig.3). The upper and the lower rollers driven by their respective shafts can rotate at the same linear velocity in a clockwise direction and a counterclockwise direction, respectively.

The elastic piece 14 is constructed such that one end thereof is secured on the fixed roller 12 and the other end thereof can freely move up and down, as shown in Fig.1. One advantage of this structure is that it allows the pressure applied by the elastic piece 14 on the thin substrate to have a large range of constant pressure area, that is, it allows the lower roller or the thin substrate itself to have a large range of roughness. Another advantage of this structure is an increased contact area between the elastic piece 14 and the thin substrate, and thus a smooth movement of the thin substrate is facilitated, especially of a flexible thin substrate.

Fig.2 is a schematic view showing that the thin substrate collectively driven by a lower roller and the elastic pieces of the upper roller shown in Fig. 1 moves towards one direction.

As shown in Fig.2, when the thin substrate 16 passes between the lower roller 18 and the upper roller, since one end of the elastic piece 14 can freely move up and down and keep a constant acting force, even if the spacing between the lower roller 18 and the fixed roller 12 of the upper roller changes, the elastic piece 14 of this invention can still press the thin substrate 16 with a constant pressure, and therefore ensures that the thin substrate 16 can always smoothly pass between the upper and lower rollers.

In a practical application, one or more roller groups may be used to transport the thin substrate 16, so that said thin substrate 16 is continuously moved towards one direction to be performed with a continuous wet-chemical treatment by using water or chemical solutions. Said continuous wet-chemical treatment includes such treatment steps as performing surface etching, surface depositing, surface cleaning, surface pattern defining, water washing or drying to the thin substrate 16.

Because the pressure applied by the elastic piece 14 on the thin substrate 16 when the upper and lower rollers maintain a certain spacing therebetween is constant, the roller group of the invention basically overcomes the drawback of the fixed rollers. That is, even if the spaces between the upper and lower rollers are different, the roller group of the invention can ensure the force applied on the thin substrate constant with the elastic piece 14.

As a transform of this embodiment, the elastic piece 14 also may be constructed such that its thickness gradually reduces from the end secured on the fixed roller 12 around it to its free end. Such a structure can have a function of making pressure applied on the thin substrate 16 gradually change.

For example, when the thin substrate 16 is chemically treated, spraying and drying are two essential operations. During these two operations, the pressure on the upper and lower surface of the thin substrate 16 may change at any time, that is, the pressure applied on the lower surface of the thin substrate 16 may be greater than that applied on the upper surface thereof. In this case, the thin substrate 16 may disengage from the lower roller 16 and then float upwards, and thus an unstable movement or damage of the thin substrate 16 is resulted in.

The roller group of this invention can completely eliminate this possibility, because if the thickness of the elastic piece 14 gradually reduces from the fixed end to the free end, then the pressure applied by it on the thin substrate 16 will increase as the thin substrate 16 floats upwards, and thus the thin substrate 16 is prevented from further rising. On the other hand, since the pressure applied on the thin substrate 16 increases as the thin substrate 16 rises, even if the thin substrate 16 disengages from the lower roller 18, due to the greater pressure received from the elastic pieces 14 of the upper roller, the thin substrate 16 driven by the upper roller also can maintain the smooth movement. Accordingly, the roller group of this invention also completely eliminates the drawbacks of said upper floating roller as described in the Background of the Invention.

In addition, the surface of the lower roller 18 may be mounted with an O-shape ring or engraved with a pattern to increase the friction with the thin substrate. The lower roller 18 also may consist of a fixed roller and elastic pieces secured on the fixed roller around it.

Fig.3 is a schematic view showing that a plurality of the upper rollers shown in Fig.1 is mounted on a shaft. As shown in Fig.3, a plurality of the upper rollers is fixed on the shaft 20 through holes at the center of the fixed rollers 12.

Fig.4 is a schematic view showing that both ends of an elastic piece of an upper roller in a roller group for transporting a thin substrate according to the second embodiment of the present invention are secured on a fixed roller having a circular section.

As shown in Fig.4, in the second embodiment, also both ends of the elastic piece 24 of the upper roller in the roller group of the invention may be secured on the fixed roller 22. The advantage of such a structure is that, since both ends of the elastic piece 24 are secured on the fixed roller 22, it has a better alignment and there is no shift of the elastic piece 24 during the rolling of the fixed roller 22, wherein the shifting of the elastic piece 24 is caused by the unevenness of the surface of the thin substrate and may result in a damage to the thin substrate and may make the elastic piece 24 and the lower roller lie not in the same vertical line. This structure is particularly suitable for the case that the elastic piece 24 is required to be very narrow, for example, the width of the elastic piece 24 is less than 3 mm.

Since the fixed roller 12 or 22 itself of the upper roller in the roller group of the invention does not contact the lower roller 18 or the thin substrate 16, there is no need for the fixed roller 12 or 22 to be circular in a section. According to the specific application of various elastic pieces 14 or 24 in different cases, the periphery shape of the fixed roller 12 or 22 of the upper roller can be randomly changed. For example, the fixed roller 12 in Fig.1 is polygonal in a section. This feature makes the roller group of the invention applicable to a wider range of applications.

It should be noted that the shape of the elastic piece 14 or 24 is not limited to be thin rectangular as shown in Fig.3. The shape may be manufactured to different shapes according to different applications.

Also, according to specific application, the width of the roller group of the invention can randomly change. For example, in the wet-chemical treatment to the flexible thin substrate, in order to ensure a smooth movement of the flexible thin substrate and reduce the damage caused by the elastic pieces, the elastic piece 14 can be designed to be relatively wide, even wider than the thin substrate. On the other hand, in order to ensure that the surface of the thin substrate is uniformly wet-chemically treated, the elastic piece 14 can be designed to be very narrow.

The material for the elastic piece 14 can be selected according to different applications. For example, for a chemical tank containing highly corrosive chemical solution, a corrosion resisting and fluorine-containing polymeric material may be used; and for some electroplating chemical tanks, in order to allow a good electrical contact between the elastic pieces 14 and the thin substrate, metal such as stainless steel sheets may be used to fabricate the elastic piece 14.

The above is an explanation to the preferable embodiments of this invention, but the invention is not limited to the above specific embodiments. The person skilled in the art may make various alterations and modifications based on this invention without departing from the spirit and essence of this invention. These alterations and modifications should fall within the protection scope claimed by the attached claims.

## Claims

1. A roller group for transporting a thin substrate, **characterized in that**:
the roller group comprises an upper roller fixed to an upper roller shaft and a lower roller fixed to a lower roller shaft, and
the upper and lower roller shafts driven by their respective driving shafts rotate the upper and lower rollers at the same linear velocity in a clockwise direction and a counter-clockwise direction respectively, so as to allow the thin substrate passing between the upper and lower rollers to move towards a certain direction under the driving of the roller group.

2. The roller group according to claim 1, wherein the upper roller includes a fixed roller (12) and a plurality of elastic pieces (14) secured on the fixed roller (12) around its outer circumference surface.

3. The roller group according to claim 2, wherein the fixed roller (12) is circular or polygonal in a section.

4. The roller group according to claim 2, wherein one end or both ends of the elastic piece (14) are secured on the fixed roller (12).

5. The roller group according to claim 1 or 2, wherein the width of the upper and lower rollers along their axes is different from the width of the thin substrate.

6. The roller group according to claim 1 or 2, wherein the upper and lower rollers are made of metal, metal oxide, metal alloy, semiconductor material or polymer material.

7. The roller group according to claim 1 or 2, wherein the lower roller includes a fixed roller and elastic pieces secured on the fixed roller around its outer circumference surface.

8. The roller group according to claim 1 or 2, wherein the surface of the lower roller is mounted with an O-shape ring or engraved with a pattern to increase the friction with the thin substrate.

9. A method for performing a chemical treatment by using the roller group for transporting a thin substrate according to claim 1, **characterized by** comprising the following steps:
using one or more sets of the roller groups to allow the thin substrate to continuously move towards one direction, so as to perform a continuous wet-chemical treatment to the thin substrate using a solution.

10. The method according to claim 9, wherein the upper roller includes a fixed roller (12) and a plurality of elastic pieces (14) secured on the fixed roller (12) around its outer circumference surface.

11. The method according to claim 10, wherein the fixed roller (12) is circular or polygonal in a section.

12. The method according to claim 10 or 11, wherein one end or both ends of the elastic piece (14) are secured on the fixed roller (12).

13. The method according to claim 9 or 10, wherein the width of the upper and lower rollers along their axes is different from the width of the thin substrate.

14. The method according to claim 9 or 10, wherein the roller group and the thin substrate are made of metal, metal oxide, metal alloy, semiconductor material or polymer material.

15. The method according to claim 9 or 10, wherein the lower roller includes a fixed roller and elastic pieces secured on the fixed roller around its outer circumference surface.

16. The method according to claim 9 or 10, wherein the surface of the lower roller is mounted with an O-shape ring or engraved with a pattern to increase the friction with the thin substrate.

17. The method according to claim 9, wherein the solution is water or a chemical solution.

18. The method according to claim 9, wherein the continuous wet-chemical treatment includes the steps of performing surface etching, surface depositing, surface cleaning, surface pattern defining, water washing or drying to the thin substrate.
